# EUROPEAN PATENT SPECIFICATION

(11) **EP 1 637 892 B1**
(45) Date of publication and mention of the grant of the patent: **12.12.2007**
(21) Application number: 03736028.6
(22) Date of filing: 04.06.2003
(51) Int. Cl.: G01R 31/28

(54) **ELECTRONIC COMPONENT HANDLING DEVICE, AND METHOD FOR TEMPERATURE APPLICATION IN ELECTRONIC COMPONENT HANDLING DEVICE**
EINRICHTUNG ZUR HANDHABUNG ELEKTRONISCHER KOMPONENTEN UND VERFAHREN FÜR TEMPERATURANWENDUNG IN EINER HANDHABUNGSEINRICHTUNG FÜR ELEKTRONISCHE KOMPONENTEN
DISPOSITIF DE MANIPULATION DE COMPOSANTS ELECTRONIQUES, ET PROCEDE D'APPLICATION D'UNE TEMPERATURE DANS UN DISPOSITIF DE GESTION DE COMPOSANTS ELECTRONIQUES

(43) Date of publication of application: 22.03.2006
(73) Proprietor: ADVANTEST CORPORATION, Nerima-ku, Tokyo 179-0071 (JP)
(72) Inventor: NAKAMURA, Hiroto, c/o Advantest Corporation, Tokyo 179-0071 (JP)
(74) Representative: Nicholls, Michael John
(86) International application number: PCT/JP2003/007082
(87) International publication number: WO 2004/109304

(56) References cited:
- JP-A- 5 074 906
- JP-A- 6 043 212
- US-A- 5 184 068
- US-A1- 2002 149 389
- US-B1- 6 414 510

## Description

### TECHNICAL FIELD

The present invention relates to an electronic device handling apparatus capable of handling electronic device assembly, such as a strip format including a plurality of IC devices or other electronic devices, to conduct a test on the plurality of electronic devices in the electronic device assembly, and a method of applying a temperature in the electronic device handling apparatus.

### BACKGOUND ART

When producing an electronic device, such as an IC device, an electronic device testing apparatus has been conventionally used for testing whether the produced electronic device is defective or not, etc. In such an electronic device testing apparatus, an electronic device handling apparatus called a handler conveys electronic devices, brings each of the respective electronic devices electrically contact with a test head under a predetermined temperature and, after conducting a test by a main testing device (tester), the electronic devices are classified to categories of good ones and defective ones, etc. in accordance with the test results.

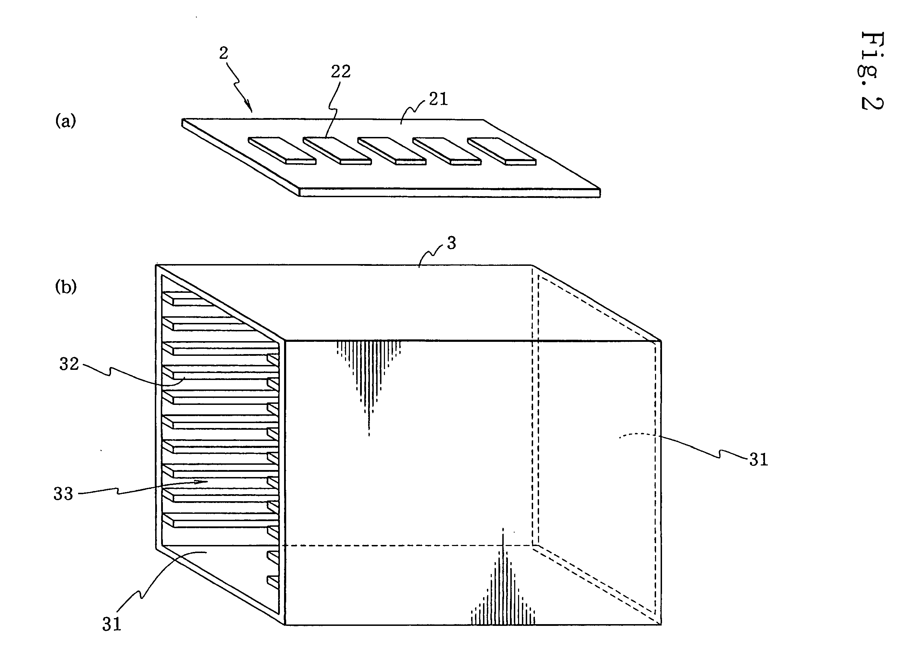

As to a form of the electronic device to be tested, what obtained by packaging each electronic device separately (an IC device, etc.) is usually the case, however, to improve an efficiency of the test, an electronic device assembly, such as a strip format obtained by forming a plurality of electronic devices on a substrate or a tape (refer to FIG. 2(a)), is tested in some cases.

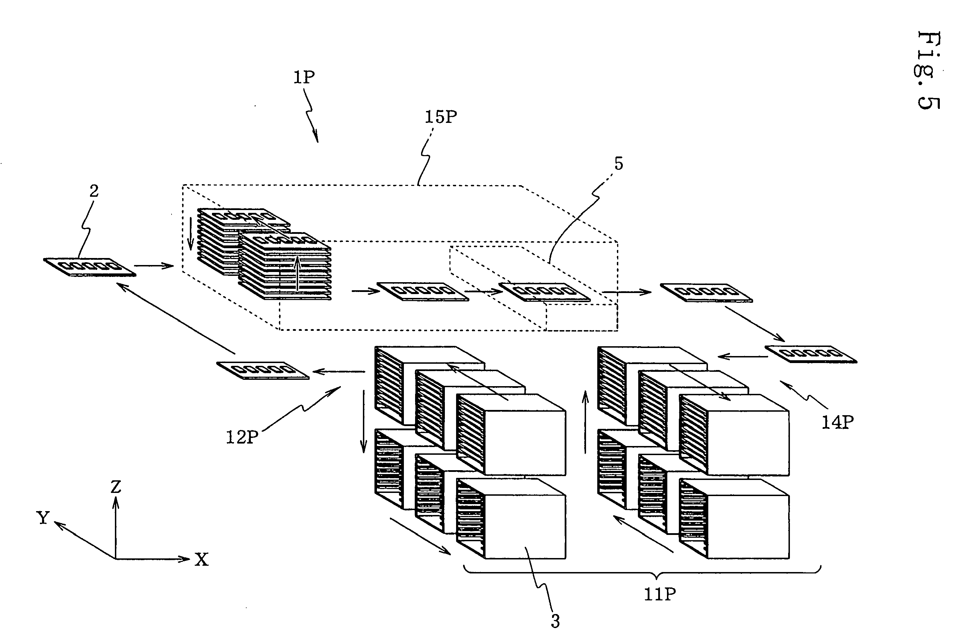

Here, a handler of the related art for testing a strip format electronic device will be explained. As shown in FIG. 5, a handler 1P of the related art comprises a storage portion 11P for storing pre-test and post-test strip formats 2, a constant temperature chamber 15P for applying a predetermined temperature to the strip formats 2 including an upper portion of the test head 5, a loader section 12P for sending the pre-test strip formats 2 stored in the storage portion 11P to the constant temperature chamber 15P, and an unloader section 14P for taking out and classifying the post-test strip formats 2 subjected to a test in the constant temperature chamber 15P. Note that the strip formats 2 in the storage portion 11P are stored in a state of being held in a magazine 3 capable of holding a plurality of strip formats 2 by stacking them.

The pre-test strip formats 2 are taken out one by one in the loader section 12P and conveyed to the constant temperature chamber 15P. After staying in the constant temperature chamber 15P for predetermined time until reaching to a predetermined temperature, the strip formats 2 are pressed against the test head 5 and tested. When the test finishes, the post-test strip formats 2 are loaded in predetermined magazines 3 and classified to categories, such as good ones and defective ones, in the unloader section 14P in accordance with the test results.

In the handler 1P of the related art, to make the strip formats 2 stay effectively in the constant temperature chamber 15P, a plurality of strip formats 2 are stepwise fed in a piled up state leaving predetermined intervals of not contacting with one another to stay in the constant temperature chamber 15P. To make the strip formats 2 stay as such, then the constant temperature chamber 15P becomes large and a device for stepwise feeding the strip formats 2 as above requires a complicated configuration. Furthermore, since the strip formats are handled in a naked state, maintenance becomes difficult in the case of a trouble.

US 2002/0149389 describes an electric device handling apparatus as disclosed in the pre-characterizing sections of claims 1 and 7. It has an in-tray burn-in board which includes a plurality of electrical contacts disposed on an interface surface for establishing, through engagement with one of more processing trays, electrical communication between the leads of the integrated circuit devices and a tester. One or more in-tray burn-in boards may each be coupled with at least one processing tray, such that a plurality of integrated circuit devices may be subjected to burn-in and other electrical testing without removing the integrated circuit devices from the processing trays, thereby reducing the time and cost associated with handling integrated circuit devices during manufacturing.

US 5,184,068 discloses a device for automatically presenting electronic devices to a tester for testing. A plurality of carriers are cyclically conveyed in a close loop from a loading stage where electronic devices are loaded onto the carriers, through a pre-test chamber, such as a "soak" chamber, front the pre-test chamber to a test stage where the devices are preferably lifted from the carter to come into contact with a test head contactor for testing, from the test stage to a post-test chamber, such as "un-soak" chamber, through the post-test chamber to an unloading stage where the carriers are unloaded of the tested electronic devices, and then from the unloading stage back to the loading stage to receive a new set of untested electronic devices.

The present invention was made in consideration of the above circumstances and has as an object thereof to provide an electronic device handling apparatus and a temperature application method in an electronic device handling apparatus capable of downsizing and simplifying a temperature application portion and improving maintainability.

According to the present invention, there is provided an electronic device handling apparatus as defined in claim 1.

The expression "conveying to the temperature applying portion" includes both of "conveying to inside the temperature applying portion" and "conveying to right in front of the temperature applying portion".

In the electronic device handling apparatus according to the invention, when applying a temperature to an electronic device assembly held in the electronic device assembly holder, a conventional stepwise feeder having a complicated configuration is not necessary and the configuration in the temperature application portion can be simplified. Also, comparing with such a stepwise feeder, the electronic device assembly holder is capable of holding electronic device assemblies at narrow pitches, so that the number of electronic device assembly per unit volume can be increased in the temperature application portion and downsizing of the temperature application portion can be attained.

Furthermore, electronic device assemblies are applied with a temperature in a state of being held in the electronic device assembly holder and not in a naked state, so that troubles are reduced and the maintainability is good.

On the other hand, the conveyor device does not convey electronic device assemblies themselves but conveys the electronic device assembly holder, so that it is possible to convey easily with a simple configuration.

With the invention, the temperature application portion may apply a predetermined temperature to electronic device assemblies held in an electronic device assembly holder conveyed by the holder conveyor.

Thus a reloading device at an inlet of the temperature application portion becomes unnecessary.

Preferably, the temperature application portion is provided with a holder conveyor for conveying the electronic device assembly holder, so that an electronic device assembly holder conveyed thereto by the holder conveyor passes through the temperature application portion and taken out from the temperature application portion (3). Accordingly, it is possible to handle the electronic device assembly holder smoothly.

The temperature application portion may be provided with a temperature application electronic device assembly holder and, it may furthermore comprise a reloading device for reloading electronic device assemblies held in a conveyor electronic device assembly holder conveyed by the holder conveyor to the temperature application electronic device assembly holder.

Accordingly, the temperature application electronic device assembly holder can be set at a predetermined temperature in advance, so that temperature application to electronic device assemblies can be performed in a short time and the test efficiency can be improved.

The electronic device assembly holder may comprise an opening portion capable of letting in and out electronic device assemblies and an electronic device assembly holding portion for holding a plurality of electronic device assemblies inserted from the opening portion at predetermined pitches, and electronic device assembly holding pitches in the conveyor electronic device assembly holder and electronic device assembly holding pitches in the temperature application electronic device assembly holder are set to be substantially the same; the holder conveyor may convey the conveyor electronic device assembly holder to a position where an opening portion of the conveyor electronic device assembly holder faces an opening portion of the temperature application electronic device assembly holder; and the reloading device may reload electronic device assemblies held by the conveyor electronic device assembly holder by sliding them to the temperature application electronic device assembly holder.

Thus, since the electronic device assemblies can be extremely easily reloaded from the conveyor electronic device assembly holder to the temperature application electronic device assembly holder, the electronic device assemblies can be introduced to the temperature application portion very efficiently comparing with the case of loading electronic device assembly one by one to a stepwise feeder as in the related art.

According to the invention, the electronic device assembly may be a strip format, and the electronic device assembly holder may be configured to be capable of holding a plurality of strip formats horizontally at predetermined pitches. Note that the present invention is not limited to that and, for example, the electronic device assembly may be a wafer, a tray holding a plurality of electronic devices or, particularly, a test tray able to be attached to the test head and capable of bringing electronic devices held therein electrically contact with the test head.

A second aspect of the invention provides a method for applying a predetermined temperature to an electronic device assembly in an electronic device handling apparatus capable of handling an electronic device assembly for testing electronic devices of the electronic device assembly, according to claim 6.

According to this second aspect of the invention, a conventional stepwise feeder having a complicated configuration is not necessary and the configuration in the temperature application portion can be simplified. Also, comparing with such a stepwise feeder, the electronic device assembly holder is capable of holding electronic device assemblies at narrow pitches, so that the number of electronic device assembly per unit volume can be increased in the temperature application portion and downsizing of the temperature application portion can be attained.

Furthermore, the electronic device assemblies are applied with a temperature in a state of being held in the electronic device assembly holder and not in a naked state, so that troubles are reduced and the maintainability is good.

As for the conveying, the electronic device assembly holder instead of the electronic device assemblies themselves can be conveyed, so that it is possible to simplify the conveyor device and to convey easily.

The electronic device assemblies held by the conveyor electronic device assembly holder conveyed to the temperature application portion may be reloaded to a temperature application electronic device assembly holder provided to the temperature application portion, and a predetermined temperature may be applied to the electronic device assemblies held by the temperature application electronic device assembly holder.

The temperature application electronic device assembly holder can be set to a predetermined temperature in advance, so that temperature application to the electronic device assemblies can be performed in a short time and the test efficiency can be improved.

Note that according to the second aspect of this invention a predetermined temperature may be applied to electronic device assemblies held in the electronic device assembly holder conveyed to the temperature application portion. Due to this, a reloading step at the inlet of the temperature application portion becomes unnecessary.

### BRIEF DESCRIPTION OF DRAWINGS

FIG. 1 is an overall view from the side of an electronic device testing apparatus including a handler according to a first embodiment of the present invention.
FIG. 2(a) is a perspective view showing an example of a strip format, and FIG. 2(b) is a perspective view showing an example of a magazine.
FIG. 3 is a schematic perspective view for explaining handling of magazines and strip formats in the handler according to the first embodiment of the present invention.
FIG. 4 is a schematic perspective view for explaining handling of magazines and strip formats in a handler in a second embodiment of the present invention.
FIG. 5 is a schematic perspective view for explaining handling of magazines and strip formats in a handler of the related art.

### BEST MODE FOR CARRYING OUT THE INVENTION

Below, embodiments of the present invention will be explained based on the drawings.

### First Embodiment

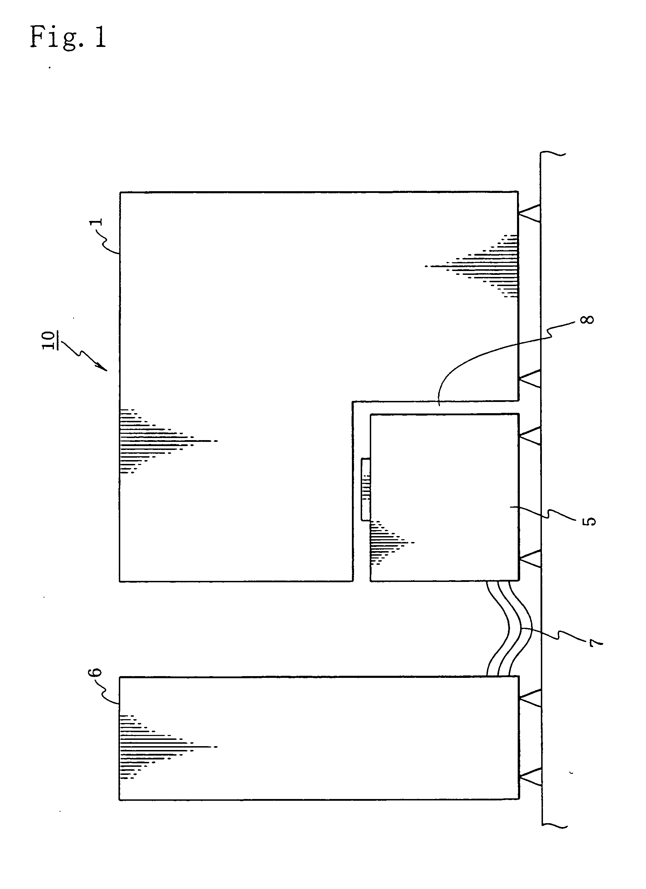

First, an overall configuration of the electronic device testing apparatus provided with an electronic device handling apparatus (herein after, referred to as "a handler") according to the first embodiment of the present invention will be explained. As shown in FIG. 1, an electronic device testing apparatus 10 comprises a handler 1, a test head 5 and a main testing device 6. The handler 1 performs an operation of successively conveying electronic devices to be tested to sockets provided on the test head 5, classifying electronic devices finished with the test in accordance with the test results and storing to predetermined holders.

The sockets provided on the test head 5 are electrically connected to the main testing device 6 through a cable 7, connects electronic devices attached detachably to the sockets to the main testing device 6 through the cable 7 and conducts a test on the electronic devices by a test electric signal from the main testing device 6.

In the lower portion of the handler 1, a control device for mainly controlling the handler 1 is incorporated and a space 8 is provided to a part thereof. The test head 5 is placed in a freely replaceable way in the space 8, and electronic devices can be mounted on the sockets on the test head 5 through a through hole formed on the handler 1.

Note that, in the present embodiment, a strip format 2 as shown in FIG. 2(a) is tested, and the strip format 2 is held in the magazine 3 as shown in FIG. 2(b).

The strip format 2 comprises, as shown in FIG. 2(a), a substrate (or a tape) 21 and a plurality of electronic devices 22, such as IC devices, formed on the substrate 21. Since external terminals of the electronic devices 22 expose on the lower surface of the substrate 21 in the strip format 2, the electronic devices 22 can be tested in a state of the strip format 2.

The magazine 3 is shaped to be a quadratic cylinder as a whole as shown in FIG. 2(b) and has opening portions 31 and 31 capable of letting in and out the strip formats 2 and a plurality of convex ridges 32 formed horizontally at predetermined pitches on the inner sidewalls. The plurality of convex ridges 32 compose a strip format holding portion 33. The strip format holding portion 33 holds a plurality of strip formats 2 inserted from the opening 31 horizontally at predetermined pitches.

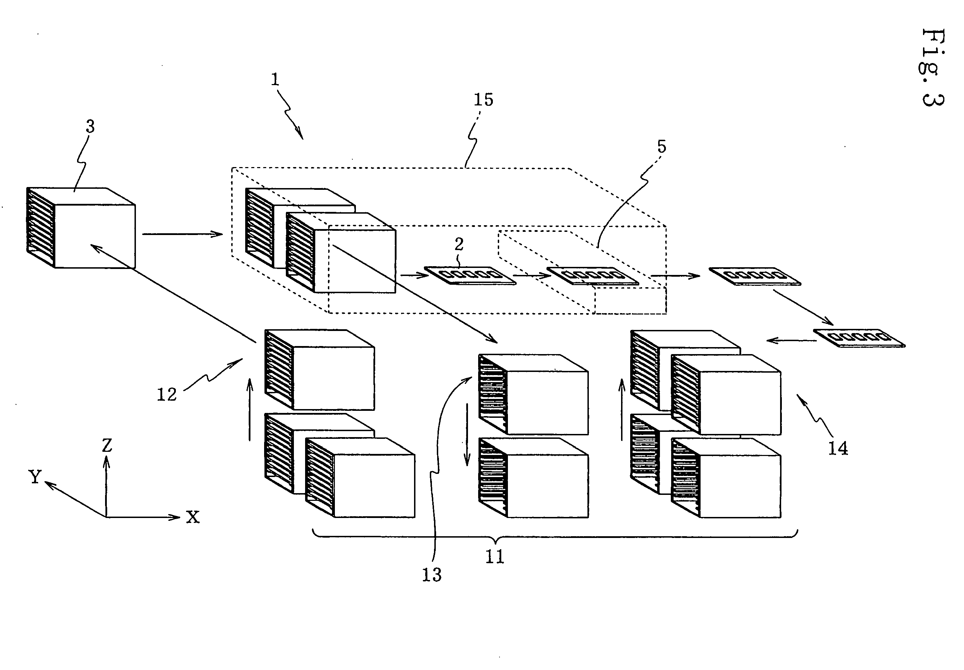

The handler 1 comprises, as shown in FIG. 3, a storage portion 11, a loader section 12, an empty magazine collector section 13, an unloader section 14, and a constant temperature chamber 15.

The storage portion 11 stores magazines 3 holding pre-test strip formats 2, empty magazines 3, and magazines 3 holding post-test strip formats 2. The storage portion 11 is provided with a conveyor device for conveying magazines 3 in the Y-axis direction and an elevator for moving magazines 3 up and down in the Z-axis direction (not shown).

The loader section 12 is a portion for sending magazines 3 holding pre-test strip formats 2 from the storage portion 11 into the constant temperature chamber 15 and provided with a conveyor device for conveying the magazines 3 in the Y-axis direction and the Y-axis direction (not shown).

The empty magazine collector portion 13 is a portion for collecting empty magazines 3 from inside the constant temperature chamber 15 and returning them to the storage portion 11 and provided with a conveyor device for conveying the magazines 3 in the Y-axis direction (not shown).

The unloader section 14 is a portion for taking out and classifying post-test strip formats 2 subjected to a test in the constant temperature chamber 15 and provided with a conveyor device for conveying the strip formats 2 in the X-axis direction and Y-axis direction and inserting to prescribed magazines 3 (not shown).

The constant temperature chamber 15 is a portion for applying a predetermined temperature (high temperature or low temperature) to the strip formats 2 and conducting a test on the strip formats 2 and configured to include an upper portion of the test head 5. In the constant temperature chamber 15, a conveyor device for taking out the strip formats 2 from the magazine 3 and conveying them to above the test head 5 is provided (not shown). The constant temperature chamber 15 in the present embodiment is provided with a magazine inlet at one end portion in the X-axis direction (on the left side in FIG. 3), a strip format outlet at the other end portion in the X-axis direction (on the right side in FIG. 3), and a magazine outlet at the front portion (front side in FIG. 3).

The conveyor devices for conveying the magazines 3 may be any kind and, for example, conveyor devices using a belt capable of loading and moving the magazines 3, those obtained by combining a rail and a loading member capable of moving on the rail, or arms capable of holding and moving the magazines 3, etc. may be used.

The conveyor devices for conveying the strip formats 2 are not particularly limited either and, for example, a conveyor device using arms capable of holding and moving the strip formats 2 and a conveyor device capable of holding the strip formats 2 by suction and moving them, etc. may be used.

In the above handler 1, magazines 3 holding a plurality of pre-test strip formats 2 move in the Y-axis direction and upward in the Z-axis direction in the storage portion 11 and position at the loader section 12. Then, the magazines 3 move in the Y-axis direction and X-axis direction in the loader section 12 so as to be fed to inside the constant temperature chamber 15 from the magazine inlet of the constant temperature chamber 15.

After staying in the constant temperature chamber 15 for predetermined time until loaded strip formats 2 reach a predetermined temperature, the magazines 3 move in the Y-axis direction by an amount of about one magazine. The strip formats 2 held in the magazines 3 are successively taken out from the magazines 3 and conveyed to above the test head 5 and pressed against the sockets of the test head 5. A test electric signal is sent from the main testing device 6 to electronic devices 22 of the strip formats 2 attached to the sockets, so that the test is conducted.

When the test finishes, the strip formats 2 are taken out from the strip format outlet of the constant temperature chamber 15, moved in the Y-axis direction and X-axis direction in the unloader section 14 and inserted to predetermined magazines 3 to be classified to categories of good ones, defective ones and ones needed to be tested again, etc. in accordance with the test results. Empty magazines 3 for holding the post-test strip formats 2 move in the Z-axis direction from the storage portion 11 and position at the unloader section 14. At this time, the empty magazines 3 move in the Z-axis direction by one pitch at a time, so that the highest level of the empty levels in the strip format holding portion 33 positions at a constant position. Magazines 3 full of post-test strip formats 2 are taken out to outside of the handler 1.

On the other hand, when all strip formats 2 held in magazines 3 are taken out, the magazines 3 in the constant temperature chamber 15 are taken out from the magazine outlet of the constant temperature chamber 15, moved in the Y-axis direction in the empty magazine collector section 13 and stored in the storage portion 11. The stored empty magazines 3 may be used for holding next pre-test strip formats 2 or moved in the X-axis direction to the unloader section 14 side in the storage portion 11 for holding post-test strip formats 2.

In the above handler 1, when introducing the strip formats 2 into the constant temperature chamber 15, it is not necessary to take out strip formats 2 one by one from a magazine 3 to load them on a stepwise feeder as in the related art, and it is possible to apply a temperature to a large number of strip formats 2 at a time. Also, the above handler 1 does not need a stepwise feeder requiring a complicated configuration, so that the configuration inside and outside of the constant temperature chamber 15 can be simplified and pitches of the strip format holding portion 33 of the magazine 3 can be narrowed easily. Consequently, the number of strip formats 2 per unit volume in the constant temperature chamber 15 can be increased and downsizing of the constant temperature chamber 15 can be attained.

Furthermore, the strip formats 2 are applied with a temperature in a state of being housed in the magazine 3 and not in a naked state in the constant temperature chamber 15, so that troubles are reduced and the maintainability is good.

### Second Embodiment

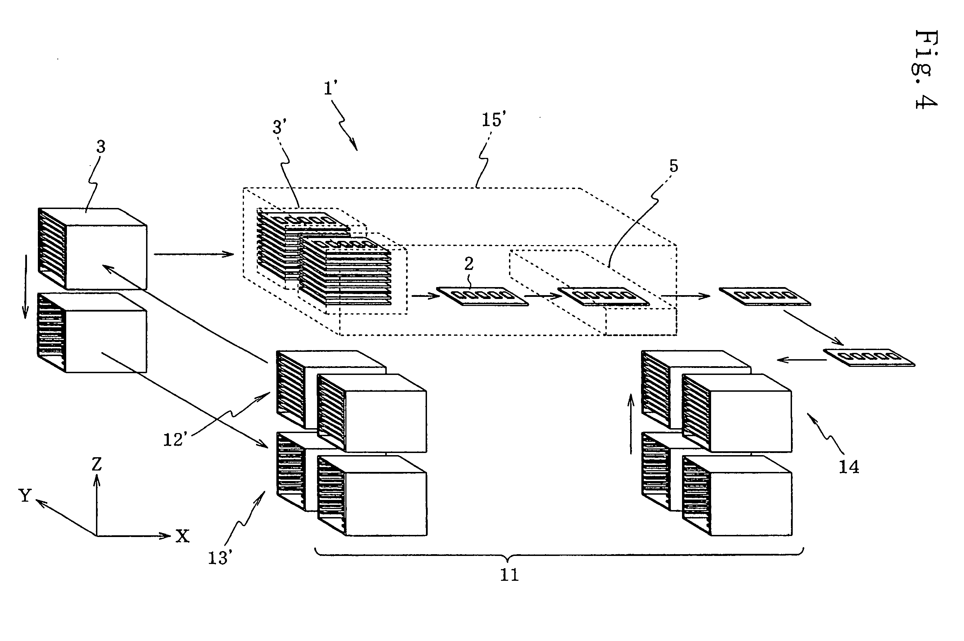

Next, a handler according to a second embodiment will be explained. As shown in FIG. 4, a handler 1' according to the second embodiment comprises a storage portion 11, a loader section 12', an empty magazine collector section 13', an unloader section 14, and a constant temperature chamber 15' as same as the handler 1 according to the first embodiment.

The storage portion 11, the unloader section 14 and the constant temperature chamber 15' have approximately the same configurations as those in the handler 1 according to the first embodiment, but the constant temperature chamber 15' is provided with a strip format inlet at one end portion in the X-axis direction (on the left side in FIG. 4) and a strip format outlet at the other end portion in the X-axis direction (on the right side in FIG. 4), and temperature application magazines 3' are provided in advance near the strip format inlet inside the constant temperature chamber 15'. The temperature application magazines 3' have the same configuration as those of magazines 3 for holding and conveying strip formats 2, so that pitches of the format holding portion 33 are same in both. In the present embodiment, two temperature application magazines 3' are provided in parallel.

The loader section 12' is a portion for moving magazines 3 holding pre-test strip formats 2 from the storage portion 11 to right in front of the constant temperature chamber 15' and reloading strip formats 2 held in magazines 3 to the temperature application magazines 3' in the constant temperature chamber 15', and provided with a conveyor device for conveying the magazines 3 in the Y-axis direction and a reloading device (not shown) for reloading strip formats 2 from the magazines 3 to the temperature application magazines 3'. The reloading device is not particularly limited and, for example, a device capable of pushing out for sliding one or a plurality of strip formats 2 held in a magazine 3, etc. may be used.

The empty magazine collector section 13' is a portion for collecting empty magazines 3 from right in front of the constant temperature chamber 15 and returning them to the storage portion 11, and provided with a conveyor device for conveying magazines 3 in the Y-axis direction (not shown).

In the above handler 1', a magazine holding a plurality of pre-test strip formats 2 moves from the storage portion 11 to the loader section 12', moves in the Y-axis direction in the loader section 12' and moves to right in front of the constant temperature chamber 15'. At this time, the magazine 3 moves right in front of the constant temperature chamber 15' on the side where an empty temperature application magazine 3' of the two temperature application magazines 3' being parallel to each other in the constant temperature chamber 15' positions, and an opening portion 31 of the magazine 3 and an opening portion 31 of the temperature application magazine 3' are aligned to be facing to each other. Note that, from the not empty temperature application magazine 3', strip formats 2 are taken out successively and conveyed 33 to above the test head 5.

Strip formats 2 held in the magazine 3 is reloaded to the temperature application magazine 3' by a reloading device. Here, pitches of the strip format holding portions are same in the magazine 3 and temperature application magazine 3' and the two are aligned, so that strip formats 2 held in the magazine 3 can be reloaded to the temperature application magazine 3' only by sliding them. Furthermore, it is possible to reload a plurality of strip formats 2 at a time by sliding to the temperature application magazine 3'.

After staying in the constant temperature chamber 15' for predetermined time until strip formats 2 reloaded to the temperature application magazine 3' reach a predetermined temperature, they are successively taken out from the temperature application magazines 3', conveyed to above the test head 5, and pressed against the sockets of the test head 5. A test electric signal is sent from the main testing device 6 to electronic devices 22 of the strip formats 2 attached to the sockets, so that the test is conducted. Handling of the post-head strip formats 2 is the same as that in the handler 1 according to the first embodiment.

On the other hand, when all of loaded strip formats 2 are taken out, the magazine 3 right in front of the constant temperature chamber 15' moves downward in the Z-axis direction in the empty magazine collector section 13', then, moves in the Y-axis direction, and stored in the storage portion 11. The empty magazine 3 stored in the empty magazine collector section 13' may be used for holding next pre-test strip formats 2 or moved to the unloader section 14 side in the X-axis direction in the storage portion 11 to hold post-test strip formats 2.

Since the above handler 1' does not need a stepwise feeder having a complicated configuration, the configuration in the constant temperature chamber 15' can be simplified and pitches of strip format holding portion 33 of the temperature application magazine 3' are narrowed easily. Therefore, the number of strip formats 2 per unit volume in the constant temperature chamber 15' can be increased and downsizing of the constant temperature chamber 15' can be attained.

Also, strip formats 2 are applied with a temperature in a state of being housed in the temperature application magazine 3' and not in a naked state in the constant temperature chamber 15', so that troubles are reduced and the maintainability is good.

Furthermore, in the above handler 1', the temperature application magazines 3' are provided in the constant temperature chamber 15' and a temperature of the temperature application magazines 3' is already at a predetermined temperature, so that temperature application to strip formats 2 can be performed in a short time comparing with that in the handler 1 according to the first embodiment, and the test efficiency can be improved.

Note that since strip formats 2 can be extremely easily reloaded from the magazine 3 to the temperature application magazine 3' in a short time as explained above, the strip formats 2 can be introduced to inside the constant temperature chamber 15' very efficiently comparing with the case of loading strip formats 2 one by one to a stepwise feeder as in the related art.

The embodiments explained above are described to facilitate understanding of the present invention and is not to limit the present invention. Accordingly, respective elements disclosed in the above embodiments include all design modifications and equivalents belonging to the technical scope of the present invention.

For example, in the above handlers 1 and 1', an unsoak chamber may be provided next to the constant temperature chambers 15 and 15'. In the unsoak chamber, the strip formats 2 can be cooled to return to the room temperature by ventilation when a high temperature is applied in the constant temperature chambers 15 and 15' or the strip formats 2 can be heated by a hot air or a heater, etc. to return to a temperature at a degree of not causing condensation when a low temperature is applied in the constant temperature chamber 15 and 15'.

Also, the above handlers 1 and 1'may handle test trays carrying a plurality of IC devices instead of the strip formats 2.

### Industrial Applicability

As explained above, according to the electronic device handling apparatus or the temperature application method in the electronic device handling apparatus of the present invention, the temperature application portion can be downsized and simplified and the maintainability can be improved. Namely, the present invention is useful for obtaining a compact and simple electronic device handling apparatus having good maintainability.

## Claims

1. An electronic device handling apparatus (1) capable of handling an electronic device assembly (2) for testing electronic devices (22) of the electronic device assembly (2), comprising:
a storage portion (11) capable of storing an electronic device assembly holder (3) capable of holding a plurality of electronic device assemblies (2);
a temperature application portion (15) capable of applying a predetermined temperature to electronic device assemblies (2) held in the electronic device assembly holder (3); and
a holder conveyor capable of conveying the electronic device assembly holder (3) from said storage portion (11) to said temperature application portion (15);
wherein the electronic device assembly holder (3) is shaped to be a quadratic cylinder as a whole and has opening portions (31) capable of letting in and out the electronic device assemblies (2);
**characterized in that**:
the electronic device assembly holder (3) has a plurality of convex ridges (32) formed horizontally at a predetermined pitch on the inner sidewalls, and the plurality of convex ridges (32) hold a plurality of electronic device assemblies (2) inserted from the opening (31) horizontally at the predetermined pitch.

2. The electronic device handling apparatus (1) as set forth in claim 1, wherein said temperature application portion(15) is provided with a holder conveyor for conveying said electronic device assembly holder (3), so that an electronic device assembly holder (3) conveyed thereto by said holder conveyor passes through said temperature application portion (15) and is taken out from said temperature application portion (15).

3. The electronic device handling apparatus (1) as set forth in claim 1, wherein said temperature application portion (15) is provided with a temperature application electronic device assembly holder (3'), furthermore comprising a reloading device for reloading electronic device assemblies (2) held in a conveyor electronic device assembly holder (3) conveyed by said holder conveyor to said temperature application electronic device assembly holder (3').

4. The electronic device handling apparatus (1) as set forth in claim 3, wherein:
said electronic device assembly holder (3) comprises an opening portion (31) capable of letting in and out electronic device assemblies (2) and an electronic device assembly holding portion (33) for holding a plurality of electronic device assemblies (2) inserted from said opening portion(31) at the predetermined pitch, and wherein the electronic device assembly holding pitch in said conveyor electronic device assembly holder (3) and the electronic device assembly holding pitch in said temperature application electronic device assembly holder (3') are set to be substantially the same;
said holder conveyor conveys said conveyor electronic device assembly holder (3) to a position where an opening portion (31) of said conveyor electronic device assembly holder (3) faces an opening portion (31) of said temperature application electronic device assembly holder (3'); and
said reloading device reloads electronic device assemblies (2) held by said conveyor electronic device assembly holder (3) by sliding them to said temperature application electronic device assembly holder (3').

5. The electronic device handling apparatus (1) as set forth in any one of claims 1 to 4, wherein said electronic device assembly (2) is a strip format, and said electronic device assembly holder (3) is configured to be capable of holding a plurality of strip formats horizontally at the predetermined pitch.

6. A temperature application method for applying a predetermined temperature to an electronic device assembly (2) in an electronic device handling apparatus (1) capable of handling an electronic device assembly (2) for testing electronic devices (22) of the electronic device assembly (2), comprising the steps of:
inserting electronic device assemblies (2) into an opening portion (31) of an electronic device assembly holder (3) which is shaped to be a quadratic cylinder as a whole and has opening portions (31) capable of letting in and out the electronic device assembly (2);
conveying the electronic device assembly holder (3) which holds the electronic device assemblies (2) to a temperature application portion (15); and
applying a predetermined temperature to electronic device assemblies (2) held in an electronic device assembly holder (3);
**characterized in that**,:
said electronic device assembly holder has a plurality of convex ridges (32) formed horizontally at a predetermined pitch on the inner sidewalls; and
said temperature application method comprises the step of holding the electronic device assemblies (2) by the plurality of convex ridges (32) horizontally at the predetermined pitch.

7. The temperature application method in an electronic device handling apparatus (1) as set forth in claim 6, wherein electronic device assemblies (2) held by the conveyor electronic device assembly holder (3) conveyed to said temperature application portion (15) are reloaded to a temperature application electronic device assembly holder (3') provided to said temperature application portion (15), and a predetermined temperature is applied to the electronic device assemblies (2) held by said temperature application electronic device assembly holder (3').

## Patentansprüche

1. Vorrichtung (1) zum Handhaben von elektronischen Einrichtungen, wobei die Vorrichtung in der Lage ist, eine Anordnung für elektronische Einrichtungen zum Testen elektronischer Einrichtungen (22) der Anordnung (2) für elektronische Einrichtungen zu handhaben, wobei die Vorrichtung aufweist:
- einen Speicherbereich (11), der in der Lage ist, einen Halter (3) für eine Anordnung für elektronische Einrichtungen zu speichern, wobei der Halter in der Lage ist, eine Mehrzahl von Anordnungen (2) für elektronische Einrichtungen zu halten;
- einen Temperatur-Anwendungsbereich (15), der in der Lage ist, eine vorgegebene Temperatur auf Anordnungen (2) für elektronische Einrichtungen anzuwenden, die in dem Halter (3) für Anordnungen für elektronische Einrichtungen gehalten werden; und
- einen Halter-Förderer, der in der Lage ist, den Halter (3) für Anordnungen für elektronische Einrichtungen von dem Speicherbereich (11) zu dem Temperatur-Anwendungsbereich (15) zu fördern;
wobei der Halter (3) für Anordnungen für elektronische Einrichtungen im Ganzen als ein quadratischer Zylinder geformt ist und Öffnungsbereiche (31) aufweist, die in der Lage sind, die Anordnungen (2) für elektronische Einrichtungen einzulassen und auszulassen;
**dadurch gekennzeichnet, dass**:
- der Halter (3) für Anordnungen für elektronische Einrichtungen eine Mehrzahl von konvexen Vorsprüngen (32) hat, die bei einem vorgegebenen Abstand horizontal an den inneren Seitenwänden ausgeformt sind, und die Mehrzahl von konvexen Vorsprüngen (32) eine Mehrzahl von Anordnungen (2) für elektronische Einrichtungen halten, die von der Öffnung (31) horizontal bei dem vorgegebenen Abstand eingeführt sind.

2. Vorrichtung (1) zum Handhaben von elektronischen Einrichtungen nach Anspruch 1, wobei der Temperatur-Anwendungsbereich (15) mit einem Halter-Förderer zum Fördern des Halters (3) für Anordnungen für elektronische Einrichtungen versehen ist, so dass ein Halter (3) für Anordnungen für elektronische Einrichtungen, der durch den Halter-Förderer da hin gefördert wird, durch den Temperatur-Anwendungsbereich (15) durchläuft und aus dem Temperatur-Anwendungsbereich (15) herausgenommen wird.

3. Vorrichtung (1) zum Handhaben von elektronischen Einrichtungen nach Anspruch 1, wobei der Temperatur-Anwendungsbereich (15) mit einem Temperaturanwendungs-Halter (3') für Anordnungen für elektronische Einrichtungen versehen ist, weiterhin aufweisend eine Umladeeinrichtung zum Umladen von Anordnungen (2) für elektronische Einrichtungen, die in einem Förderer-Halter (3) für Anordnungen für elektronische Einrichtungen gehalten werden, gefördert durch den Halter-Förderer zu dem Temperaturanwendungs-Halter (3') für Anordnungen für elektronische Einrichtungen.

4. Vorrichtung (1) zum Handhaben von elektronischen Einrichtungen nach Anspruch 3, wobei
- der Halter (3) für Anordnungen für elektronische Einrichtungen einen Öffnungsbereich (31) aufweist, der in der Lage ist, Anordnungen (2) für elektronische Einrichtungen einzulassen und auszulassen, und einen Haltebereich (33) für Anordnungen für elektronische Einrichtungen zum Halten einer Mehrzahl von Anordnungen (2) für elektronische Einrichtungen, die von dem Öffnungsbereich (31) bei dem vorgegebenen Abstand eingeführt sind, aufweist und wobei der Halteabstand für Anordnungen für elektronische Einrichtungen in dem Förderer-Halter (3) für Anordnungen für elektronische Einrichtungen und der Halteabstand für Anordnungen für elektronische Einrichtungen in dem Temperaturanwendungs-Halter (3') für Anordnungen für elektronische Einrichtungen eingerichtet sind, im Wesentlichen gleich zu sein;
- der Halter-Förderer den Förderer-Halter (3) für Anordnungen für elektronische Einrichtungen zu einer Position fördert, wo ein Öffnungsbereich (31) des Förderer-Halters (3) für Anordnungen für elektronische Einrichtungen einem Öffnungsbereich (31) des Temperaturanwendungs-Halters (3') für Anordnungen für elektronische Einrichtungen gegenüber liegt; und
- die Umladeeinrichtung Anordnungen (2) für elektronische Einrichtungen umlädt, die von dem Förderer-Halter (3) für Anordnungen für elektronische Einrichtungen gehalten werden, indem sie zu dem Temperaturanwendungs-Halter (3') für Anordnungen für elektronische Einrichtungen gleiten gelassen werden.

5. Vorrichtung (1) zum Handhaben von elektronischen Einrichtungen nach einem der Ansprüche 1 bis 4, wobei die Anordnung (2) für elektronische Einrichtungen ein Streifenformat ist und der Halter (3) für Anordnungen für elektronische Einrichtungen ausgestaltet ist, in der Lage zu sein, eine Mehrzahl von Streifenformaten horizontal bei dem vorgegebenen Abstand zu halten.

6. Temperaturanwendungsverfahren zum Anwenden einer vorgegebenen Temperatur auf eine Anordnung (2) für elektronische Einrichtungen in einer Vorrichtung (1) zum Handhaben für elektronische Einrichtungen, die in der Lage ist, eine Anordnung (2) für elektronische Einrichtungen zum Testen für elektronische Einrichtungen (22) der Anordnung (2) für elektronische Einrichtungen zu handhaben, wobei das Verfahren die Schritte aufweist:
- Einführen von Anordnungen (2) für elektronische Einrichtungen in einen Öffnungsbereich (31) eines Halters (3) für Anordnungen für elektronische Einrichtungen, der im Ganzen als ein quadratischer Zylinder geformt ist und Öffnungsbereiche (31) hat, die in der Lage sind, die Anordnung (2) für elektronische Einrichtungen einzulassen und auszulassen;
- Fördern des Halters (3) für Anordnungen für elektronische Einrichtungen, der die Anordnungen (2) für elektronische Einrichtungen hält, zu einem Temperaturanwendungs-Bereich (15); und
- Anwenden einer vorgegebenen Temperatur auf die Anordnungen (2) für elektronische Einrichtungen, die in einem Halter (3) für Anordnungen für elektronische Einrichtungen gehalten werden;
**dadurch gekennzeichnet, dass**:
- der Halter für Anordnungen für elektronische Einrichtungen eine Mehrzahl von konvexen Vorsprüngen (32) hat, die horizontal bei einem vorgegebenen Abstand an den inneren Seitenwänden geformt sind; und
- das Temperaturanwendungsverfahren den Schritt aufweist, die Anordnungen (2) für elektronische Einrichtungen durch die Mehrzahl von konvexen Vorsprüngen (32) horizontal bei dem vorgegebenen Abstand zu halten.

7. Temperaturanwendungsverfahren in einer Vorrichtung (1) zum Handhaben für elektronische Einrichtungen nach Anspruch 6, wobei Anordnungen (2) für elektronische Einrichtungen, die von dem Förderer-Halter (3) für Anordnungen für elektronische Einrichtungen gehalten werden, gefördert zu dem Temperaturanwendungs-Bereich (15), in einen Temperaturanwendungs-Halter (3') für Anordnungen für elektronische Einrichtungen umgeladen werden, der für den Temperaturanwendungs-Bereich (15) bereitgestellt ist, und eine vorgegebene Temperatur wird auf die Anordnungen (2) für elektronische Einrichtungen, die von dem Temperaturanwendungs-Halter (3') für Anordnungen für elektronische Einrichtungen gehalten werden, angewendet.

## Revendications

1. Appareil de manipulation de composants électroniques (1) capable de manipuler un assemblage de composants électroniques (2) testant des composants électroniques (22) de l'assemblage de composants électroniques (2), comprenant :
une partie de stockage (11) capable de stocker un support d'assemblages de composants électroniques (3) capable de contenir une pluralité d'assemblages de composants électroniques (2) ;
une partie d'application d'une température (15) capable d'appliquer une température prédéterminée aux assemblages de composants électroniques (2) contenus dans le support d'assemblages de composants électroniques (3) ; et
un convoyeur de support capable de transporter le support d'assemblages de composants électroniques (3) à partir de ladite partie de stockage (11) jusqu'à ladite partie d'application d'une température (15) ;
dans lequel le support d'assemblages de composants électroniques (3) présente une forme de cylindre quadratique dans son ensemble et présente des parties d'ouverture (31) permettant d'introduire et de retirer les assemblages de composants électroniques (2) ;
**caractérisé en ce que** :
le support d'assemblages de composants électroniques (3) présente une pluralité de nervures convexes (32) formées horizontalement sur les parois latérales intérieures selon un pas prédéterminé, et la pluralité de nervures convexes (32) supportent une pluralité d'assemblages de composants électroniques (2) insérés horizontalement à partir de l'ouverture (31) selon le pas prédéterminé.

2. Appareil de manipulation de composants électroniques (1) selon la revendication 1, dans lequel ladite partie d'application d'une température (15) est dotée d'un convoyeur de support transportant ledit support d'assemblages de composants électroniques (3), de telle sorte qu'un support d'assemblages de composants électroniques (3) transporté par ledit convoyeur de support passe à travers ladite partie d'application d'une température (15) et sorte de ladite partie d'application d'une température (15).

3. Appareil de manipulation de composants électroniques (1) selon la revendication 1, dans lequel ladite partie d'application d'une température (15) est dotée d'un support d'assemblages de composants électroniques d'application d'une température (3'), comprenant de plus un dispositif de rechargement rechargeant les assemblages de composants électroniques (2) contenus dans un support d'assemblages de composants électroniques de convoyeur (3) transporté par ledit convoyeur de support vers ledit support d'assemblages de composants électroniques d'application d'une température (3').

4. Appareil de manipulation de composants électroniques (1) selon la revendication 3, dans lequel :
ledit support d'assemblages de composants électroniques (3) comprend une partie d'ouverture (31) permettant d'introduire et de retirer les assemblages de composants électroniques (2) et une partie de support d'assemblages de composants électroniques (33) supportant une pluralité d'assemblages de composants électroniques (2) insérés à partir de ladite partie d'ouverture (31) selon le pas prédéterminé, et dans lequel le pas de support des assemblages de composants électroniques dans ledit support d'assemblages de composants électroniques de convoyeur (3), et le pas de support des assemblages de composants électroniques dans ledit support d'assemblages de composants électroniques d'application d'une température (3'), sont fixés de manière à être sensiblement identiques ;
ledit convoyeur de support transporte ledit support d'assemblages de composants électroniques de convoyeur (3) vers une position où une partie d'ouverture (31) dudit support d'assemblages de composants électroniques de convoyeur (3) fait face à une partie d'ouverture (31) dudit support d'assemblages de composants électroniques d'application d'une température (3') ; et
ledit dispositif de rechargement recharge les assemblages de composants électroniques (2) supportés par ledit support d'assemblages de composants électroniques de convoyeur (3) en les glissant dans ledit support d'assemblages de composants électroniques d'application d'une température (3').

5. Appareil de manipulation de composants électroniques (1) selon l'une quelconque des revendications 1 à 4, dans lequel ledit assemblage de composants électroniques (2) présente un format de bande, et ledit support d'assemblages de composants électroniques (3) est configuré de manière à être capable de supporter horizontalement une pluralité de formats de bande selon le pas prédéterminé.

6. Procédé d'application d'une température appliquant une température prédéterminée à un assemblage de composants électroniques (2) dans un appareil de manipulation de composants électroniques (1) capable de manipuler un assemblage de composants électroniques (2) testant des composants électroniques (22) de l'assemblage de composants électroniques (2), comprenant les étapes consistant à :
insérer des assemblages de composants électroniques (2) dans une partie d'ouverture (31) d'un support d'assemblages de composants électroniques (3) qui présente dans son ensemble une forme de cylindre quadratique et présente des parties d'ouverture (31) permettant d'introduire et de retirer les assemblages de composants électroniques (2) ;
transporter le support d'assemblages de composants électroniques (3) qui supporte les assemblages de composants électroniques (2) vers une partie d'application d'une température (15) ; et
appliquer une température prédéterminée aux assemblages de composants électroniques (2) supportés dans un support d'assemblages de composants électroniques (3) ;
**caractérisé en ce que** :
ledit support d'assemblages de composants électroniques présente une pluralité de nervures convexes (32) formées horizontalement sur les parois latérales intérieures selon un pas prédéterminé ; et
ledit procédé d'application d'une température comprend l'étape consistant à faire supporter les assemblages de composants électroniques (2) par la pluralité de nervures convexes (32) horizontalement selon le pas prédéterminé.

7. Procédé d'application d'une température dans un appareil de manipulation de composants électroniques (1) selon la revendication 6, dans lequel lesdits assemblages de composants électroniques (2) supportés par le support d'assemblages de composants électroniques de convoyeur (3) transporté vers ladite partie d'application d'une température (15), sont rechargés vers un support d'assemblages de composants électroniques d'application d'une température (3') fourni à ladite partie d'application d'une température (15), et une température prédéterminée est appliquée aux assemblages de composants électroniques (2) supportés par ledit support d'assemblages de composants électroniques d'application d'une température (3').
